# FASCICULE DE BREVET EUROPEEN

(11) **EP 3 654 045 B1**
(45) Date de publication et mention de la délivrance du brevet: **17.05.2023**
(21) Numéro de dépôt: 19206834.4
(22) Date de dépôt: 04.11.2019
(51) Int. Cl.: G01R 31/12, G01R 31/27, G01R 31/34, G01R 31/14, G01R 31/62

(54) **PROCEDE DE DETECTION ET DE TRANSMISSION D'INFORMATION DE PANNE DORMANTE**
DETEKTIONS- UND ÜBERTRAGUNGSVERFAHREN VON INFORMATION ÜBER EINEN SCHLAFENDEN FEHLER
METHOD FOR DETECTING AND TRANSMITTING INFORMATION ABOUT A DORMANT FAILURE

(30) Priorité: 08.11.2018 FR 1871452
(43) Date de publication de la demande: 20.05.2020
(73) Titulaire: Thales, 92400 Courbevoie (FR)
(72) Inventeur: MAIRIE, Mathieu, 78400 CHATOU (FR); BIAUJAUD, Rémy, 78400 CHATOU (FR); MARIADASSOU, Prithu, 78400 CHATOU (FR)
(74) Mandataire: Atout PI Laplace

(56) Documents cités:
- EP-A1- 0 228 012
- EP-A2- 1 684 395
- CN-A- 105 699 836
- CN-Y- 201 007 733
- US-A- 4 660 014
- US-A1- 2013 271 166
- US-A1- 2013 282 312
- US-B2- 6 870 374
- BORN F H ET AL: "MARGINAL CHECKING - A TECHNIQUE TO DETECT INDIPIENT FAILURES", PROCEEDINGS OF THE NATIONAL AEROSPACE AND ELECTRONICS CONFERENCE. (NAECON). DAYTON, MAY 22 - 26, 1989; [PROCEEDINGS OF THE NATIONAL AEROSPACE AND ELECTRONICS CONFERENCE. (NAECON)], NEW YORK, IEEE, US, vol. 4 OF 04, 22 mai 1989 (1989-05-22), pages 1880-1886, XP000076541,
- MASAYUKI KOIDO ET AL: "PREVENTIVE MAINTENANCE TECHNIQUE FOR HIGH VOLTAGE INDUCTION MOTORS", HITACHI REVIEW, HITACHI LTD. TOKYO, JP, vol. 40, no. 2, 1 avril 1991 (1991-04-01), pages 151-160, XP000264682, ISSN: 0018-277X

## Description

L'invention concerne un procédé de détection et de transmission d'information de panne dormante d'un équipement électrique dans un environnement critique dans lequel une non-détection d'une panne dormante, par exemple panne du dispositif permettant de détecter une rupture d'isolement dans un transformateur, peut présenter un risque pour les personnes et les installations.

Un transformateur permet de convertir une source d'énergie électrique alternative en énergie magnétique et inversement, l'énergie convertie étant de même fréquence que l'énergie de la source initiale. Il est constitué d'enroulements primaire et secondaire qui ne présentent aucune liaison électrique entre eux, uniquement un couplage magnétique. Il est alimenté par une ou plusieurs tensions alternatives, appelées phases, chacune via un enroulement primaire qui constitue une entrée du transformateur. Un ou plusieurs enroulements secondaires constituent les sorties du transformateur. Un ensemble d'enroulements primaire et secondaire dépendant d'une même tension d'entrée est appelée bobine. Il y a donc autant de bobines que de phases en entrée du transformateur. Le transformateur permet d'échanger de l'énergie entre les enroulements primaires et les enroulements secondaires sans qu'ils aient à échanger des électrons grâce au couplage magnétique. Le passage par un support magnétique permet de créer un isolement galvanique entre l'énergie électrique traversant l'enroulement primaire et l'énergie électrique traversant l'enroulement secondaire, et d'élever ou d'abaisser les amplitudes des tensions ou courants entrant dans l'enroulement primaire et ressortant dans l'enroulement secondaire par le rapport de transformation du transformateur. Il peut également fournir le même niveau de tension ou courant entre l'entrée et la sortie du transformateur et juste servir d'isolement galvanique.

Cependant, si cet isolement galvanique disparaît, on parle de rupture d'isolement, les électrons peuvent circuler de l'enroulement primaire vers l'enroulement secondaire et le rapport de transformation du transformateur n'est plus garanti. Ainsi, la tension de l'enroulement secondaire peut, dans le cas d'un transformateur abaisseur de tension ou élévateur de courant, monter au-dessus de la tension pour laquelle les équipements qui lui sont connectés sont conçus et entraîner leur destruction.

De plus, la rupture d'isolement peut être soudaine et indétectable, et dans les transformateurs actuels, utilisés par exemple en aéronautique, elle peut générer instantanément « un mode de défaillance redouté », comme l'augmentation de la tension dans les enroulements secondaires. Afin de limiter l'apparition du défaut de perte d'isolement, il est possible de placer des écrans métalliques, entourés d'isolants thermiques, entre les enroulements primaire et secondaire, les écrans étant reliés à la masse électrique par un câblage dédié. La détection de la rupture d'isolement se fait alors à l'aide, par exemple, de la mesure d'un courant de fuite à la masse. Cependant, le point faible de cette solution réside dans la mise à la masse des écrans. Si la liaison écran/masse est perdue, alors la détection est impossible, puisque cette liaison n'est pas utilisée dans le cadre d'une utilisation nominale. En l'absence d'un contrôle dédié, la rupture de liaison entre l'écran et la masse forme un exemple de panne dormante.

Afin d'éviter la perte de liaison entre la masse et l'écran, ou plus généralement entre une charge non-utilisée en utilisation en nominale et un conducteur d'alimentation, il est possible de renforcer la liaison électrique pour éviter sa dégradation en fonctionnement et prendre des précautions particulières en fabrication pour ne pas injecter de défauts pouvant conduire à une casse par la suite. Néanmoins, la perte de liaison reste non détectable et constitue donc toujours une panne dormante.

Les documents US687037482, CN201007733Y et US4660014A divulguent la détection de défauts dans des transformateurs.

L'invention vise à surmonter les inconvénients et limitations précités de l'art antérieur. Plus précisément, elle vise à proposer un procédé de détection et de transmission d'information de panne dormante et un équipement électrique capable de détecter une panne dormante, comme par exemple la perte de liaison entre un écran métallique et un conducteur d'alimentation.

Un objet de l'invention est donc un équipement électrique comprenant une première charge configurée pour une utilisation nominale de l'équipement, au moins un premier écran métallique, un capteur configuré pour mesurer une grandeur caractéristique de la première charge, et un conducteur d'alimentation, caractérisé en ce que la première charge et le au moins premier écran métallique sont reliés électriquement au conducteur d'alimentation, et en ce que l'équipement comprend également un comparateur configuré de manière à comparer des mesures du capteur pour détecter une panne dormante du au moins premier écran métallique.

L'invention concerne un équipement selon la revendication 1 ainsi qu'un procédé selon la revendication 8. Des modes de réalisation de l'invention sont décrits dans les revendications dépendantes.

Selon des modes de réalisation particuliers de l'invention :
- le comparateur et le capteur sont configurés de manière à détecter une perte de liaison entre le conducteur d'alimentation et le au moins premier écran métallique ;
- le au moins premier écran métallique est placé entre un enroulement primaire et un enroulement secondaire d'un transformateur électrique ;
- la première charge est choisie parmi un ventilateur, un contacteur et une carte électronique ;
- l'équipement comprend un second écran métallique relié en série ou en parallèle au au moins premier écran métallique par le conducteur d'alimentation ; et
- le second écran métallique est relié en série au au moins premier écran métallique et le comparateur et le capteur sont configurés de manière à détecter une perte de liaison entre le second écran métallique et le au moins premier écran métallique.

Un autre objet de l'invention est un procédé de détection de la panne dormante et de mise en sécurité d'un équipement selon l'invention relié à un système d'alimentation électrique, caractérisé en ce qu'il comprend les étapes suivantes :
a) définir une plage de valeurs d'une grandeur caractéristique de la première charge garantissant le bon fonctionnement de l'équipement ;
b) mesurer avec le capteur la grandeur caractéristique de la première charge ;
c) comparer avec le comparateur les grandeurs mesurées à l'étape b) avec la plage de valeurs définie à l'étape a) ; et
d) couper la liaison au système d'alimentation électrique de l'équipement si la grandeur mesurée à l'étape b) est hors de la plage définie à l'étape a).

Selon un mode de réalisation particulier de l'invention, la grandeur mesurée dans l'étape b) est choisie parmi une vitesse, un courant électrique, une tension ou une température.

D'autres caractéristiques, détails et avantages de l'invention ressortiront à la lecture de la description faite en référence aux figures annexées données à titre d'exemple et qui représentent, respectivement :
- la figure 1, un équipement électrique selon un premier mode de réalisation de l'invention ;
- la figure 2, un équipement électrique selon un second mode de réalisation de l'invention ;
- la figure 3, un équipement électrique selon un troisième mode de réalisation de l'invention ;
- les figures 4a et 4b, un équipement électrique selon respectivement un quatrième mode et un cinquième mode de réalisation de l'invention ; et
- la figure 5, un procédé de détection et de transmission d'une panne dormante selon un mode de réalisation de l'invention.

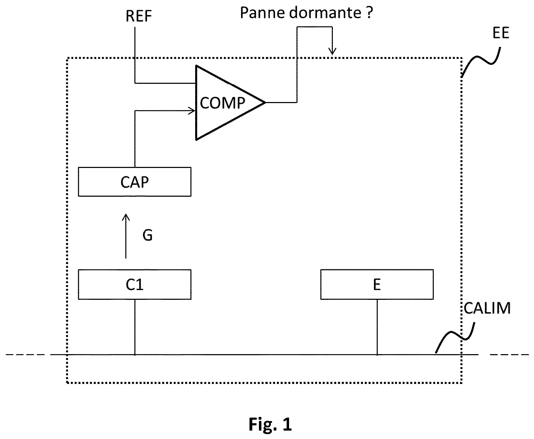

La figure 1 présente un équipement électrique EE selon un premier mode de réalisation de l'invention. L'équipement électrique EE comprend une première charge C1 et un écran métallique E. La première charge C1 est configurée pour une utilisation nominale de l'équipement EE tandis que l'écran métallique E est configuré pour détecter une panne de l'équipement EE. La charge C1 et l'écran E sont reliés électriquement au même conducteur d'alimentation CALIM. L'équipement EE comprend également un capteur CAP configuré pour mesurer une grandeur G caractéristique de la première charge C1, et un comparateur COMP configuré pour comparer des mesures de la grandeur G caractéristique de la première charge C1 et mesurées par le capteur CAP.

Selon un mode de réalisation, le comparateur COMP peut comparer les valeurs mesurées de G entre elles dans le temps ou comparer les valeurs de G à une référence REF. Cette référence REF peut être, par exemple, une valeur particulière de la grandeur G ou un intervalle de valeurs de G. La référence REF définit, par exemple, une valeur ou un intervalle garantissant le bon fonctionnement de l'équipement EE. Cette comparaison permet de détecter une panne dormante de l'équipement EE. Par exemple, la panne dormante peut être une panne au niveau de l'écran métallique E, comme une perte de liaison entre l'écran E et le conducteur d'alimentation CALIM.

Selon un mode de réalisation, l'équipement électrique EE est un transformateur électrique comprenant un écran métallique E placé entre un enroulement primaire et un enroulement secondaire d'une bobine du transformateur électrique.

Selon des modes de réalisation de l'invention, le comparateur COMP est un circuit électrique comprenant, par exemple, un amplificateur opérationnel, ou le comparateur COMP est un calculateur.

Selon des modes de réalisation, la première charge C1 est un élément de l'équipement EE dont un signal ou une des grandeurs caractéristiques est contrôlé en permanence lors de l'utilisation nominale de l'équipement.

Selon des modes de réalisation, le capteur CAP est un capteur de température, ou de courant électrique ou de tension ou de vitesse.

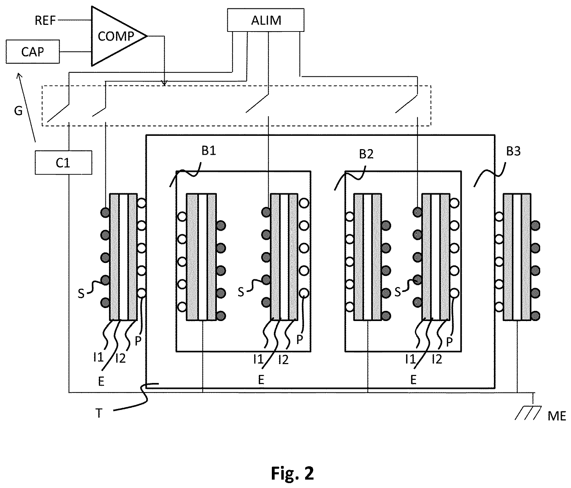

La figure 2 présente un équipement électrique selon un second mode de réalisation de l'invention. Dans ce mode de réalisation, l'équipement électrique est un transformateur T comprenant trois écrans métalliques E placés, chacun, entre un enroulement primaire P et un enroulement secondaire S de trois bobines (B1, B2, B3). Les écrans métalliques E sont chacun entourés de deux couches d'isolants thermiques I1 et 12. Les écrans métalliques E des différentes bobines B1, B2 et B3 sont reliés entre eux en parallèle, et sont reliés à un même conducteur d'alimentation, comme par exemple une masse électrique ME. La première charge C1 est également reliée à cette même masse électrique ME. Le transformateur T est alimenté en énergie par un système d'alimentation électrique ALIM. Un capteur CAP permet de mesurer une grandeur caractéristique G de la première charge C1. Un comparateur COMP reçoit ces mesures de G et les compare entre elles ou à une grandeur de référence REF. Comme précédemment, la référence REF peut être une valeur ou une plage de valeurs. Cette comparaison permet, dans ce mode de réalisation, de détecter une perte de liaison entre la masse électrique ME et les écrans E.

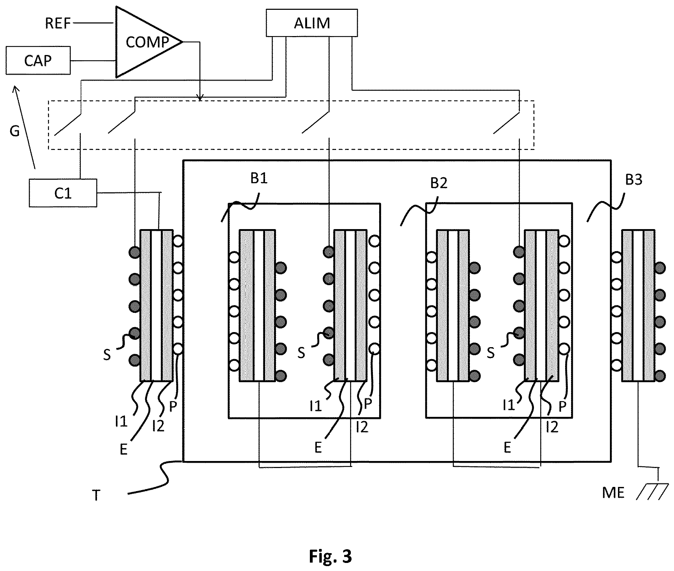

Il est possible de relier les écrans métalliques E entre eux en série, comme ce qui est illustré en figure 3. La figure 3 présente un équipement électrique selon un troisième mode de réalisation de l'invention. Dans ce mode de réalisation, l'équipement électrique est un transformateur T comprenant trois bobines (B1, B2, B3). Les bobines B1, B2, B3 comprennent chacune, entre un enroulement primaire P et un enroulement secondaire S, un écran métallique E entouré de deux isolants thermiques I1 et I2. Les écrans E sont reliés entre eux en série. Au moins un des écrans est relié à une masse électrique ME, et la première charge C1 est au moins reliée à un écran E. Comme précédemment, le transformateur T est alimenté en énergie par un système d'alimentation électrique ALIM et un capteur CAP permet de mesurer une grandeur caractéristique G de la première charge C1. Un comparateur COMP reçoit ces mesures de G et les compare entre elles ou à une grandeur de référence REF. La référence REF peut être une valeur ou une plage de valeurs. Comme dans la figure 2, cette comparaison permet de détecter une perte de liaison entre la masse électrique ME et les écrans E.

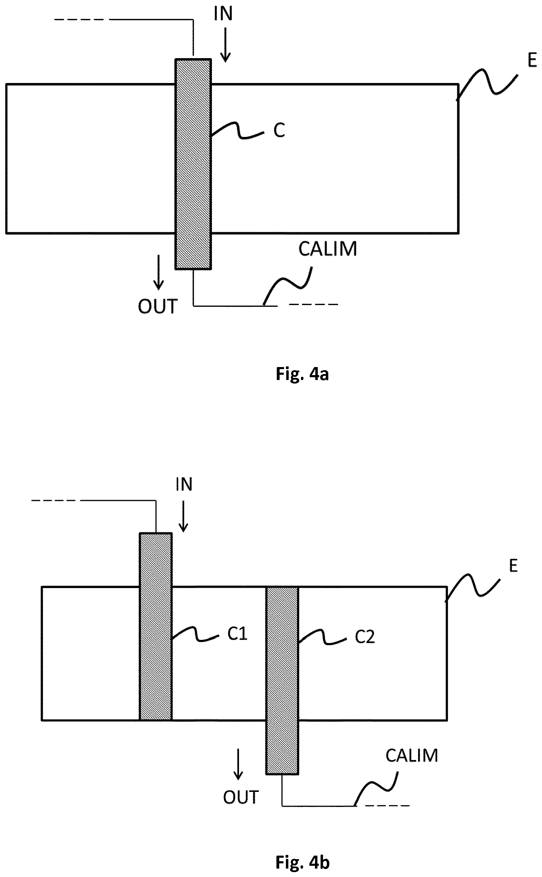

La mise en série des écrans E permet notamment de pouvoir détecter une perte de liaison entre le conducteur d'alimentation, comme la masse électrique ME, et un écran E, mais aussi de détecter une perte de liaison entre deux écrans E, si la connexion entre l'écran E et le conducteur d'alimentation est choisie de manière adéquate (figures 4a et 4b).

Les figures 4a et 4b présentent respectivement une vue de l'écran E selon un quatrième et cinquième mode de réalisation, et plus particulièrement le type de connexion reliant un écran E au conducteur d'alimentation CALIM.

La figure 4a présente notamment une vue de l'écran E déplié avec une connexion C « traversante » au conducteur CALIM. Donc si un défaut de connexion entre l'écran E et le conducteur CALIM apparaît, le courant pourra quand même circuler entre l'entrée IN et la sortie OUT de la connexion C, donc on ne pourra pas détecter la perte de liaison entre l'écran E et le conducteur CALIM et donc si un défaut d'isolement se produit, il sera également indétectable.

La figure 4b présente une vue de l'écran E déplié avec des connexions distinctes C1 pour l'entrée IN et C2 pour la sortie OUT du conducteur d'alimentation CALIM. Les deux connexions C1 et C2 peuvent être placées l'une à côté de l'autre ou opposées de 180° quand l'écran E est enroulé autour de la bobine. Il est également possible d'avoir l'entrée IN et la sortie OUT opposées, comme c'est le cas sur la figure 4b ou du même côté. Si une des connexions C1 ou C2 présente un défaut de connexion avec l'écran E, le courant ne pourra pas circuler entre l'entrée IN et la sortie OUT du conducteur CALIM et on pourra donc détecter le défaut de connexion contrairement à une connexion « traversante ».

Selon plusieurs modes de réalisation de l'invention, la première charge C1 peut être un ventilateur, ou une carte électronique ou un contacteur.

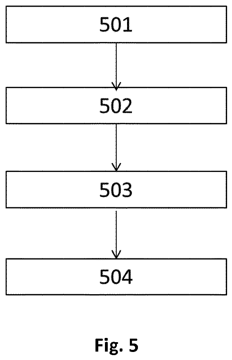

La figure 5 présente un procédé de détection et de transmission d'une panne dormante d'un équipement électrique selon un mode de réalisation de l'invention. Ce procédé s'applique sur un équipement électrique tel que ceux décrits précédemment, alimenté par un système d'alimentation. La première étape 501 consiste à définir une plage de valeurs ou une valeur référence d'une grandeur caractéristique de la première charge. Cette plage de valeurs ou cette référence garantissent le bon fonctionnement de l'équipement. La seconde étape 502 consiste à mesurer la grandeur caractéristique de la première charge avec le capteur de l'équipement. Ces mesures sont ensuite transmises à un comparateur (étape 503) qui va comparer les mesures à la plage de valeurs ou à la valeur de référence. Si les mesures appartiennent à la plage de valeurs définie, aucun défaut ou panne n'est détecté et l'équipement continue d'être alimenté, alors que si les mesures n'appartiennent pas à la plage de valeurs définie (étape 504), alors on coupe l'alimentation électrique de l'équipement.

Selon plusieurs modes de réalisation, la grandeur mesurée caractéristique de la première charge peut être :
- une vitesse, par exemple si la première charge est un ventilateur, cela peut être la vitesse de rotation du ventilateur ; ou
- une température, on peut, par exemple, mesurer une température d'une carte électrique, d'une diode, d'un transformateur ; ou
- un courant électrique ; ou
- une tension électrique.

En effet, quelle que soit la nature de la première charge, on peut mesurer le courant traversant cette charge, la tension aux bornes de cette charge, ou la température de cette charge. Dans le cas d'un transformateur comprenant un écran métallique entre les différents enroulements primaires et secondaires, la panne dormante peut par exemple être la perte de liaison entre la masse électrique et l'écran. Si la première charge est un ventilateur, en cas de perte de liaison, le ventilateur arrêtera de tourner, donc la mesure de sa vitesse de rotation permettra bien de détecter cette panne dormante. Si la première charge est une carte électronique, en cas de perte de liaison, la température de la carte augmentera et soit on détectera cette hausse de température, soit l'information concernant cette température ne sera pas reçue. Que l'on reçoive ou non l'information de température, cela ne sera pas la valeur de référence ou la plage de référence REF, donc la perte de liaison sera détectée. Si on mesure un courant, en cas de perte de liaison, le courant chutera et comme précédemment, soit on détectera la chute de courant, soit l'information concernant les valeurs de courant de la première charge ne seront pas reçues, donc la perte de liaison sera également détectée.

## Revendications

1. Equipement électrique (EE) comprenant :
- un transformateur (T) comprenant un enroulement primaire (P), au moins un enroulement secondaire (S) et au moins un premier écran métallique ;
- une première charge (C1) configurée pour une utilisation nominale de l'équipement ;
- un capteur (CAP); et
- un conducteur d'alimentation (CALIM : ME),
**caractérisé en ce que** le au moins un premier écran métallique (E) est placé entre l'enroulement primaire (P) et le au moins un enroulement secondaire (S), **en ce que** la première charge et le au moins premier écran métallique sont reliés électriquement au conducteur d'alimentation, **en ce que** le capteur (CAP) est configuré pour mesurer une grandeur caractéristique de la première charge, et **en ce que** l'équipement comprend également un comparateur (COMP) configuré de manière à comparer des mesures du capteur pour détecter une panne dormante du au moins premier écran métallique.

2. Equipement électrique selon la revendication 1 dans lequel le comparateur et le capteur sont configurés de manière à détecter une perte de liaison entre le conducteur d'alimentation et le au moins premier écran métallique.

3. Equipement électrique selon l'une des revendications 1 à 2 dans lequel la première charge est choisie parmi un ventilateur, un contacteur et une carte électronique.

4. Equipement électrique selon l'une des revendications 1 à 3 comprenant un second écran métallique relié en série ou en parallèle au au moins premier écran métallique par le conducteur d'alimentation.

5. Equipement électrique selon la revendication 4 dans lequel le second écran métallique est relié en série au au moins premier écran métallique et le comparateur et le capteur sont configurés de manière à détecter une perte de liaison entre le second écran métallique et le au moins premier écran métallique.

6. Équipement électrique selon la revendication 5 dans lequel la première charge (C1) est reliée au conducteur d'alimentation (CALIM; ME) par l'intermédiaire du premier et du second écrans métalliques reliés en série.

7. Équipement électrique selon l'une des revendications précédentes comprenant en outre un système d'alimentation électrique (ALIM) alimentant en parallèle la première charge (C1) et le transformateur (T).

8. Procédé de détection de la panne dormante et de mise en sécurité d'un équipement selon l'une des revendications 1 à 5 relié à un système d'alimentation électrique, comprenant les étapes suivantes :
a) définir une plage de valeurs d'une grandeur caractéristique de la première charge garantissant le bon fonctionnement de l'équipement ;
b) mesurer avec le capteur la grandeur caractéristique de la première charge ;
c) comparer avec le comparateur les grandeurs mesurées à l'étape b) avec la plage de valeurs définie à l'étape a) ; et
d) couper la liaison au système d'alimentation électrique de l'équipement si la grandeur mesurée à l'étape b) est hors de la plage définie à l'étape a).

9. Procédé de détection selon la revendication précédente dans lequel la grandeur mesurée dans l'étape b) est choisie parmi une vitesse, un courant électrique, une tension ou une température.

## Patentansprüche

1. Elektrische Ausrüstung (EE), die Folgendes umfasst:
- einen Transformator (T), der eine Primärwicklung (P), mindestens eine Sekundärwicklung (S) und mindestens eine erste Metallabschirmung umfasst;
- eine erste Last (C1), die für einen Nennbetrieb der Ausrüstung konfiguriert ist;
- einen Sensor (CAP); und
- einen Stromversorgungsleiter (CALIM:ME).
**dadurch gekennzeichnet, dass** die mindestens eine erste Metallabschirmung (E) zwischen der Primärwicklung (P) und der mindestens einen Sekundärwicklung (S) platziert ist, dadurch, dass die erste Last und die mindestens erste Metallabschirmung elektrisch mit dem Stromversorgungsleiter verbunden sind, dadurch, dass der Sensor (CAP) zum Messen einer für die erste Last charakteristischen Größe konfiguriert ist, und dadurch, dass die Ausrüstung auch einen Komparator (COMP) umfasst, der zum Vergleichen von Messwerten des Sensors konfiguriert ist, um einen latenten Fehler der mindestens ersten Metallabschirmung zu erkennen.

2. Elektrische Ausrüstung nach Anspruch 1, wobei der Komparator und der Sensor zum Erkennen eines Verlusts der Verbindung zwischen dem Stromversorgungsleiter und der mindestens ersten Metallabschirmung konfiguriert sind.

3. Elektrische Ausrüstung nach einem der Ansprüche 1 bis 2, wobei die erste Last aus einem Lüfter, einem Schütz und einer elektronischen Karte ausgewählt ist.

4. Elektrische Ausrüstung nach einem der Ansprüche 1 bis 3, der eine zweite Metallabschirmung umfasst, die über den Stromversorgungsleiter in Reihe oder parallel mit der mindestens ersten Metallabschirmung verbunden ist.

5. Elektrische Ausrüstung nach Anspruch 4, wobei die zweite Metallabschirmung in Reihe mit der mindestens ersten Metallabschirmung verbunden ist, und der Komparator und der Sensor so konfiguriert sind, dass sie einen Verlust der Verbindung zwischen der zweiten Metallabschirmung und der mindestens ersten Metallabschirmung erkennen.

6. Elektrische Ausrüstung nach Anspruch 5, wobei die erste Last (C1) über die erste und die zweite in Reihe geschaltete Metallabschirmung mit dem Stromversorgungsleiter (CALIM; ME) verbunden ist.

7. Elektrische Ausrüstung nach einem der vorhergehenden Ansprüche, die ferner ein Stromversorgungssystem (ALIM) umfasst, das die erste Last (C1) und den Transformator (T) parallel mit Strom versorgt.

8. Verfahren zum Erkennen des latenten Fehlers und zum Sichern einer mit einem Stromversorgungssystem verbundenen Ausrüstung nach einem der Ansprüche 1 bis 5, das die folgenden Schritte umfasst:
a) Definieren eines Wertebereichs einer charakteristischen Größe der ersten Last, der den ordnungsgemäßen Betrieb der Ausrüstung gewährleistet;
b) Messen, mit dem Sensor, der charakteristischen Größe der ersten Last;
c) Vergleichen, mit dem Komparator, der in Schritt b) gemessenen Größen mit dem in Schritt a) definierten Wertebereich; und
d) Unterbrechen der Verbindung zum Stromversorgungssystem der Ausrüstung, wenn die in Schritt b) gemessene Größe außerhalb des in Schritt a) definierten Bereichs liegt.

9. Erkennungsverfahren nach dem vorhergehenden Anspruch, wobei die in Schritt b) gemessene Größe aus einer Geschwindigkeit, einem elektrischen Strom, einer Spannung oder einer Temperatur ausgewählt wird.

## Claims

1. Electrical equipment (EE) comprising:
- a transformer (T), comprising a primary winding (P), at least one secondary winding (S) and at least one first metal screen;
- a first load (C1) configured for a nominal use of the equipment;
- a sensor (CAP); and
- a power supply conductor (CALIM:ME),
**characterised in that** the at least one first metal screen (E) is placed between the primary winding (P) and the at least one secondary winding (S), **in that** the first load and the at least first metal screen are linked electrically to the power supply conductor, **in that** the sensor (CAP) is configured to measure a quantity characteristic of the first load, and **in that** the equipment also comprises a comparator (COMP) configured so as to compare measurements from the sensor to detect a dormant failure of the at least first metal screen.

2. Electrical equipment according to claim 1, wherein the comparator and the sensor are configured so as to detect a loss of link between the power supply conductor and the at least first metal screen.

3. Electrical equipment according to one of claims 1 to 2, wherein the first load is chosen from a fan, a contactor and an electronic card.

4. Electrical equipment according to one of claims 1 to 3, comprising a second metal screen linked in series or in parallel to the at least first metal screen by the power supply conductor.

5. Electrical equipment according to claim 4, wherein the second metal screen is linked in series to the at least first metal screen, and the comparator and the sensor are configured so as to detect a loss of link between the second metal screen and the at least first metal screen.

6. Electrical equipment according to claim 5, wherein the first load (C1) is linked to the power supply conductor (CALIM; ME) through the first and the second metal screens, which are linked in series.

7. Electrical equipment according to one of the preceding claims, further comprising an electric power supply system (ALIM) powering the first load (C1) and the transformer (T) in parallel.

8. Method for detecting the dormant failure and ensuring the safety of an equipment according to one of claims 1 to 5, linked to an electrical power supply system, comprising the following steps:
a) defining a range of values of a quantity characteristic of the first load, guaranteeing the proper functioning of the equipment;
b) measuring, with the sensor, the quantity characteristic of the first load;
c) comparing, with the comparator, the quantities measured in step b) with the range of values defined in step a); and
d) cutting the link to the electrical power supply system of the equipment if the quantity measured in step b) is outside of the range defined in step a).

9. Detection method according to the preceding claim, wherein the quantity measured in step b) is chosen from a speed, an electrical current, a voltage or a temperature.
